# FASCICULE DE BREVET EUROPEEN

(11) **EP 1 276 226 B1**
(45) Date de publication et mention de la délivrance du brevet: **30.07.2008**
(21) Numéro de dépôt: 02077427.9
(22) Date de dépôt: 19.06.2002
(51) Int. Cl.: H03B 5/12

(54) **Circuit destiné à générer une conductance négative substantiellement constante en fonction de la fréquence**
Schaltung zur Erzeugung einer negativen, relativ frequenzunabhängigen Konduktanz-
Substantially frequency-independent negative conductance generator

(30) Priorité: 26.06.2001 FR 0108419
(43) Date de publication de la demande: 15.01.2003
(73) Titulaire: NXP B.V., 5656 AG Eindhoven (NL)
(72) Inventeur: Amiot, Sébastian, 75008 Paris (FR); Duloy, Bertrand, 75008 Paris (FR)
(74) Mandataire: White, Andrew Gordon

(56) Documents cités:
- US-A- 4 169 248
- PATENT ABSTRACTS OF JAPAN vol. 001, no. 138 (E-063), 12 novembre 1977 (1977-11-12) & JP 52 074263 A (SONY CORP), 22 juin 1977 (1977-06-22)

## Description

La présente invention concerne un circuit électronique destiné à générer entre deux bornes une conductance négative.

De tels circuits sont souvent utilisés en association avec des circuits résonnants de manière à former des oscillateurs offrant un régime d'oscillation bien maîtrisé. En effet, un circuit résonnant usuel comprend des composants passifs, par exemple un élément inductif et un élément capacitif couplés en parallèle, qui présentent une conductance positive intrinsèque qui, lorsque l'oscillateur est en régime d'oscillation, provoque des pertes qui tendent à amortir le régime d'oscillation, c'est-à-dire à provoquer une diminution progressive d'amplitude de signaux générés par l'oscillateur. La conductance négative générée par le circuit électronique associé au circuit résonnant permet de compenser ces pertes et de préserver le régime d'oscillation.

Un montage d'un circuit résonnant en association avec un circuit destiné à générer une conductance négative est connu des pages 27 et 35 de la notice technique des circuits TDA6502 et TDA6503 commercialisés par la demanderesse, qui sont des mélangeurs/oscillateurs intégrés destinés à former partie de syntoniseurs dans des appareils récepteurs de signaux audio/vidéo, comme des téléviseurs, des magnétoscopes ou des boîtiers-décodeurs.
Ce montage inclut un premier et un deuxième transistor connectés en paire différentielle et présentant des bornes de polarisation formant les bornes de connexion du circuit, des bornes de transfert reliées à une borne d'alimentation via des résistances de charge, et des bornes de référence.
Dans le montage connu, les premier et deuxième transistors sont des transistors bipolaires présentant des bases, collecteurs et émetteurs constituant respectivement leurs bornes de polarisation, de transfert et de référence.
Le montage connu inclut en outre un premier élément capacitif disposé entre les bornes de polarisation et de transfert des premier et deuxième transistors, respectivement, et un deuxième élément capacitif disposé entre les bornes de polarisation et de transfert des deuxième et premier transistors, respectivement.
Les premier et deuxième éléments capacitifs créent des contre-réactions qui permettent d'obtenir une conductance négative.
Le montage connu présente les inconvénients suivants :
Tout d'abord, les éléments capacitifs ne pouvant être aisément réalisés sous forme intégrée, leurs connexions à la paire différentielle qui est, elle, incluse dans un circuit intégré, nécessite de munir ledit circuit intégré de deux bornes de connexion externes supplémentaires reliées aux bornes de transfert des premier et deuxième transistors. La réalisation de ces bornes de connexion entraîne un surcoût qui se répercute sur le prix de revient total du circuit intégré qui inclut la paire différentielle. De plus, les éléments capacitifs eux-mêmes génèrent un surcoût pour l'utilisateur dudit circuit intégré.
Par ailleurs, l'effet des contre-réactions réalisées par les éléments capacitifs n'est pas constant en fonction de la fréquence de fonctionnement du montage. Ceci entraîne que la valeur de la conductance négative sera amenée à varier en fonction de la fréquence, et donc que les pertes générées par la conductance positive intrinsèque au circuit résonnant indus dans l'oscillateur ne pourront pas être compensées de manière homogène dans la totalité de la plage de variation de la fréquence d'oscillation, ce qui provoque une dégradation de pureté spectrale des signaux générés par l'oscillateur. Ce phénomène est relativement inoffensif dans des applications de réception de signaux de télévision câblée ou hertzienne analogique, mais devient préjudiciable dans des applications de réception de signaux de télévision numériques hertziens, pour lesquels des normes imposent la présence de 2000 à 8000 porteuses différentes dans des canaux de 8MHz, applications pour lesquelles on comprend bien que la pureté spectrale d'un signal délivré par l'oscillateur, dont la fréquence d'oscillation déterminera, au sein d'un syntoniseur, une fréquence de porteuse à sélectionner, est cruciale.

Le document US-A-4 169 248 décrit aussi un circuit oscillant qui génère un premier et un deuxième signal de référence déphasés de 90°. Ce circuit comprend un oscillateur générant le premier signal de référence sur une sortie, un convertisseur tension-courant, qui peut comprendre un transistor monté en base commune, et une capacité connectée entre ladite sortie et une entrée dudit convertisseur. La sortie dudit convertisseur génère le deuxième signal de référence.

Le document JP52074263 décrit aussi un circuit oscillant comprenant une structure push-pull dans lequel un circuit résonnant est connecté entre les collecteurs de transistors formant une paire différentielle.

L'invention a pour but de remédier à ces inconvénients en proposant un oscillateur comprenant un circuit électronique destiné à générer entre deux bornes une conductance négative présentant une valeur substantiellement constante en fonction de la fréquence de fonctionnement dudit circuit, lequel peut être entièrement réalisé sous forme intégrée et un circuit résonnant connecté entre ces bornes.

A cet effet, un oscillateur destiné à générer entre deux bornes une conductance négative inclut, selon l'invention, un premier et un deuxième transistor connectés en paire différentielle et présentant des bornes de polarisation formant les bornes de connexion du circuit, des bornes de transfert reliées à une borne d'alimentation via des résistances de charge, et des bornes de référence, circuit incluant en outre un premier composant actif disposé entre les bornes de polarisation et de transfert des premier et deuxième transistors, respectivement, et un deuxième composant actif disposé entre les bornes de polarisation et de transfert des deuxième et premier transistors, respectivement, et un circuit résonnant connecté entre les bornes de polarisation.

Les premier et deuxième composants actifs réalisent une contre-réaction permettant d'amener un courant négatif sur la borne de polarisation de celui des transistors de la paire différentielle qui est le plus conducteur à un instant donné. Ce courant négatif permet de générer la conductance négative.

L'utilisation de composants actifs pour réaliser les contre-réactions permet de réaliser le circuit décrit ci-dessus entièrement sous forme intégrée. Les composants actifs ayant un comportement substantiellement invariant pour de larges plages de fréquences, la valeur de la conductance négative générée grâce à l'invention sera substantiellement constante pour l'ensemble de la plage de variation de la fréquence de fonctionnement du circuit.

Dans un mode de réalisation particulier de l'invention, les premier et deuxième composants actifs sont constitués par des jonctions incluses dans des troisième et quatrième transistors.

Dans une variante de ce mode de réalisation, les troisième et quatrième transistors sont montés en diode, ce qui permet, en court-circuitant des capacités parasites présentes entre les bornes de transfert et de polarisation desdits transistors, d'améliorer la linéarité du circuit et l'invariance de la valeur de la conductance négative qu'il est destiné à générer.

On pourra en outre améliorer la linéarité du circuit en insérant des résistances de dégénérescence entre les bornes de référence des premier et deuxième transistors.

Ainsi qu'exposé précédemment, le circuit conforme à l'invention sera couplé à un circuit résonnant afin de compenser des pertes générées par celui-ci. L'invention concerne donc un oscillateur incluant un élément inductif et un élément capacitif agencés pour former un circuit résonnant destiné à produire un signal ayant une fréquence d'oscillation réglable en fonction de la capacité de l'élément capacitif, oscillateur incluant en outre un circuit électronique destiné à générer une conductance négative tel que décrit plus haut, connecté audit circuit résonnant.

Un tel oscillateur délivrera un signal présentant une grande pureté spectrale, ce qui le rendra particulièrement apte à être utilisé au sein d'un syntoniseur destiné à opérer une sélection de signaux en entrée d'un appareil récepteur, comme un téléviseur, un magnétoscope, un boîtier-décodeur ou encore un radiotéléphone.

La connexion du circuit résonnant est faite au niveau des bases des transistors T1 et T2. L'intérêt d'un tel oscillateur est d'améliorer les performances en bruit de phase, le bruit de phase étant causé par la modulation du bruit intrinsèque du circuit actif au niveau du résonateur. La paire différentielle formée par les transistors T1 et T2 réalise un système d'amplification et de conversion d'une tension (situé sur la base des transistors) en courant (au niveau du collecteur des transistors). Un important rapport signal sur bruit de phase est obtenu dans la mesure où l'amplitude des oscillations est importante (mais pas trop importante cependant pour ne pas perturber l'ensemble du circuit), et que le bruit est ramené en entrée sans être amplifié.

L'invention concerne également un appareil récepteur de signaux radioélectriques, incluant :
. un étage d'entrée destiné à recevoir un signal ayant une fréquence radio,
. un oscillateur destiné à produire un signal ayant une fréquence d'oscillation, et
. un mélangeur destiné à produire un signal ayant une fréquence intermédiaire ayant une valeur égale à une différence entre les valeurs des fréquences radio et d'oscillation, appareil dans lequel l'oscillateur est tel que décrit ci-dessus.

L'invention sera mieux comprise à l'aide de la description suivante, faite à titre d'exemple non-limitatif et en regard des dessins annexés, dans lesquels :
- la figure 1 est un schéma électrique décrivant un circuit électronique selon un mode de réalisation de l'invention,
- la figure 2 est un schéma équivalent en petits signaux alternatifs d'un transistor inclus dans un tel circuit,
- la figure 3 est schéma électrique décrivant un circuit électronique selon un variante du mode de réalisation de l'invention précédemment décrit,
- la figure 4 est un schéma électrique décrivant un oscillateur selon un mode de mise en oeuvre de l'invention,
- la figure 5 est un diagramme fréquentiel illustrant la substantielle invariance de la valeur de conductance négative obtenue grâce à l'invention, et
- la figure 6 est un schéma fonctionnel d'un appareil récepteur selon un mode de mise en oeuvre avantageux de l'invention.

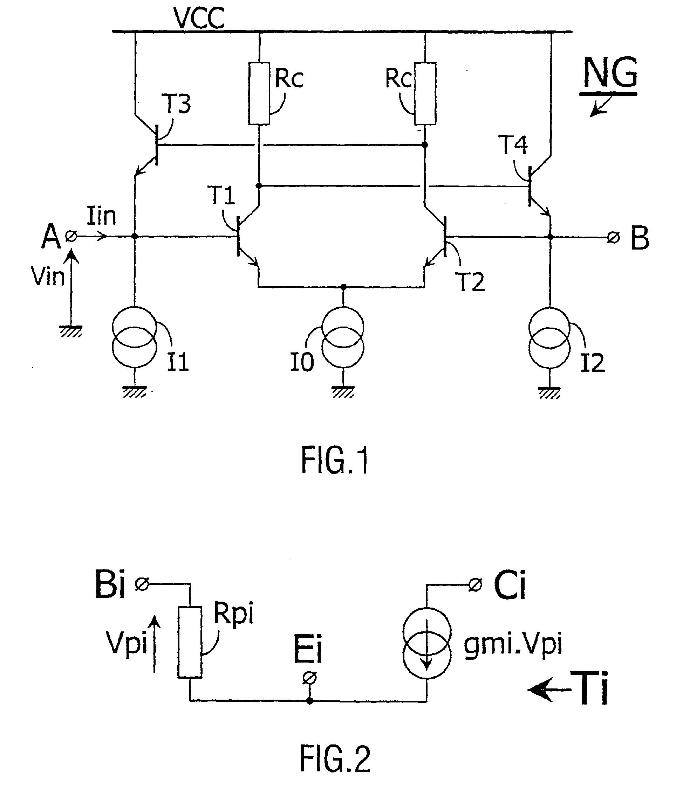

La figure 1 représente schématiquement un circuit électronique destiné à générer entre deux bornes de connexion A et B une conductance négative NG, incluant un premier et un deuxième transistor T1 et T2 connectés de manière à former une paire différentielle. Ces transistors sont ici réalisés en technologie bipolaire et présentent des bases, collecteurs et émetteurs formant respectivement des bornes dites de polarisation, de transfert et de référence. Il est tout à fait envisageable de leur substituer des transistors réalisés en technologie MOS, dont des grilles, drains et sources formeraient alors respectivement les bornes de polarisation, de transfert et de référence.
Les bornes de polarisation des premier et deuxième transistors T1 et T2 forment les bornes de connexion A et B du circuit NG, les bornes de transfert desdits transistors étant reliées à une borne d'alimentation VCC via des résistances de charge RC, les bornes de référence des premier et deuxième transistors T1 et T2 étant reliées ensemble à une masse du circuit via une source de courant 10 destinée à polariser la paire différentielle.
Le circuit électronique NG inclut en outre un premier composant actif disposé entre les bornes de polarisation et de transfert des premier et deuxième transistors T1 et T2, respectivement, et un deuxième composant actif disposé entre les bornes de polarisation et de transfert des deuxième et premier transistors T2 et T1, respectivement. Les premier et deuxième composants actifs sont matérialisés dans cet exemple par des troisième et quatrième transistors T3 et T4, respectivement, disposés en suiveur et polarisés par des sources de courant I1 et I2.
Les premier et deuxième composants actifs réalisent une contre-réaction permettant d'amener un courant négatif sur la borne de polarisation de celui des transistors de la paire différentielle qui est le plus conducteur à un instant donné. Ce courant négatif permet de générer une conductance négative.

La figure 2 est un schéma électrique équivalent en petits signaux alternatifs qui représente un transistor Ti. Ce transistor Ti présente, dans une approximation au premier ordre, une résistance Rpi entre sa base Bi et son émetteur Ei, laquelle résistance est destinée à générer une tension Vpi. Le transistor Ti présente en outre une source de courant destinée à débiter un courant de valeur gmi.Vpi entre le collecteur Ci et l'émetteur Ei du transistor Ti, gmi étant une transconductance propre au transistor Ti.
Ce schéma équivalent, appliqué au circuit représenté à la figure 1, permet d'expliciter la valeur de la conductance négative NG=Iin/Vin générée par ledit circuit. Cette valeur s'écrit :
NG=(1/Rp3+Rc)[1-Rc.gm2-(Rp3+Rc)/Rpl], et est donc bien, dans cette approximation au premier ordre, indépendante de la fréquence de fonctionnement du circuit.

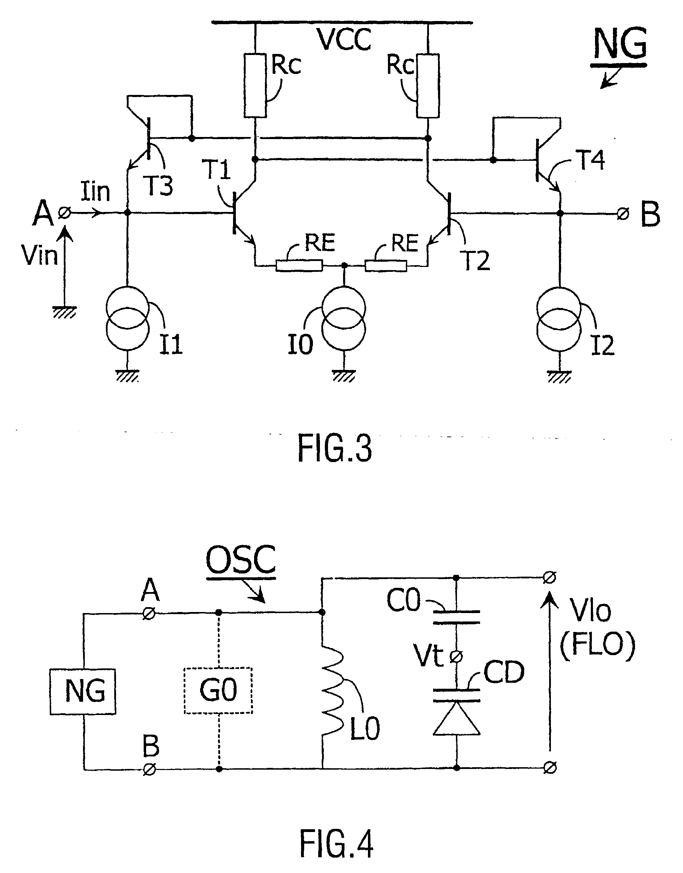

La figure 3 représente schématiquement une variante du circuit décrit plus haut, dans lequel les éléments communs à ceux de la figure 1 portent les mêmes référence et ne seront pas à nouveau décrits. Selon cette variante, les troisième et quatrième transistors T3 et T4 sont montés en diode, c'est-à-dire que leurs collecteurs sont reliés à leurs base, ce qui permet de court-circuiter les capacités parasites notoirement existantes entre les bases et les collecteurs de tout transistor, bien que n'apparaissant pas dans le schéma équivalent décrit plus haut en tant qu'approximation au premier ordre. Ceci permet d'améliorer la linéarité du circuit et l'invariance en fonction de la fréquence de fonctionnement dudit circuit de la conductance négative qu'il est destiné à générer. Pour améliorer encore la linéarité du circuit, des résistances de dégénérescence RE ont été insérées entre les émetteurs des premier et deuxième transistors T1 et T2. La valeur de la conductance négative NG=Iin/Vin générée par ce circuit s'écrit alors : NG=(1/Rp3+Rc)[1-(Rp1/(Rp1+RE)).(Rc.gm2-(Rp3+Rc)/Rp1)], et est toujours théoriquement indépendante de la fréquence de fonctionnement du circuit.

La figure 4 représente schématiquement un oscillateur commandé en tension OSC, destiné à produire un signal Vlo ayant une fréquence d'oscillation FLO réglable en fonction de la valeur d'une tension Vt appliquée à une borne de réglage de l'oscillateur. Cet oscillateur OSC inclut un élément inductif L0 et un élément capacitif (C0, CD) disposés en parallèle pour former un circuit résonnant. L'élément capacitif est, dans cet exemple, constitué par une capacité C0 disposée en série avec une diode varicap CD, un noeud intermédiaire entre ces deux composants formant la borne de réglage. La diode varicap a pour particularité de présenter une capacité ayant une valeur variable en fonction de sa tension de polarisation, qui est ici la tension de réglage Vt. Le circuit résonnant est donc destiné à produire un signal Vlo oscillant à une fréquence FLO=(2Π.L0.Ceq)^{-1/2}, où Ceq est égal à C0.CD/(C0+CD). Le circuit résonnant présente cependant une conductance positive parasite G0, représentée en pointillés, inhérente à l'association des éléments inductif et capacitif qui le composent, qui a pour effet, si elle n'est pas compensée, d'altérer le régime d'oscillation en provoquant une diminution progressive de l'amplitude du signal de sortie Vlo, phénomène connu sous le terme d'amortissement. Afin de compenser l'effet néfaste de cette conductance parasite positive G0, l'oscillateur OSC inclut en outre un circuit destiné à générer une conductance négative NG tel que décrit plus haut, qui permet une compensation des pertes dues au circuit résonnant, compensation qui est rendue homogène sur toute la plage de variation de la fréquence d'oscillation FLO grâce à l'invention. Dans d'autres applications, les éléments inductif et capacitif pourront être disposés en série, auquel cas le circuit destiné à générer la conductance négative NG sera avantageusement connecté en série au circuit résonnant série ainsi constitué.

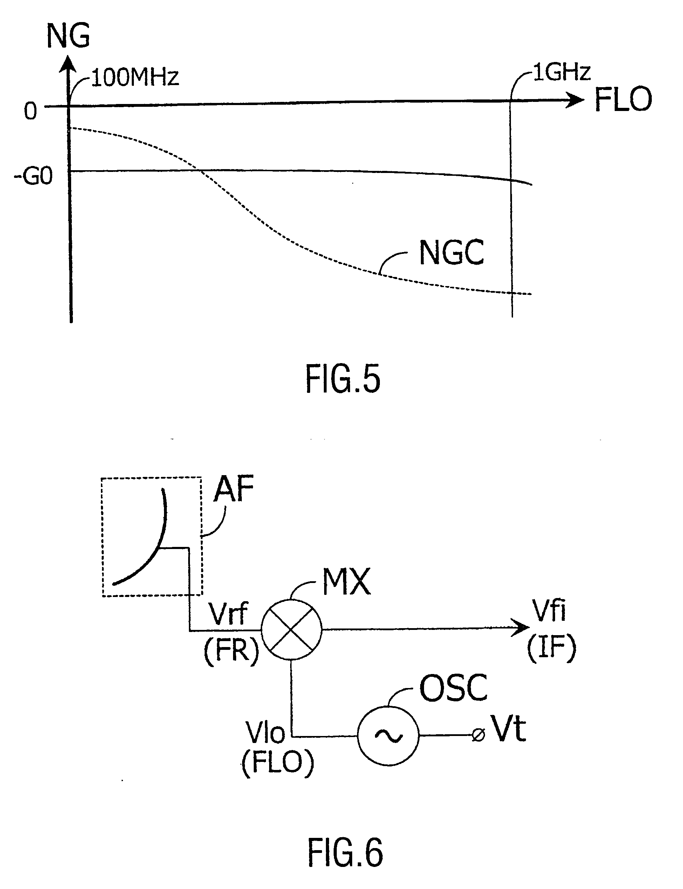

La figure 5 est un diagramme fréquentiel qui illustre cet avantage. Ce diagramme représente l'évolution de la valeur de la conductance négative NG générée par le circuit conforme à l'invention, sur une plage de valeurs de la fréquence d'oscillation FLO allant de 100MHz à 1 GHz, qui sont des valeurs correspondant à celles qu'un oscillateur utilisé dans un syntoniseur destiné à la réception de signaux numériques terrestres doit être capable de produire.
On constate que la conductance négative NG obtenue grâce à l'invention est substantiellement invariante en fonction de la fréquence d'oscillation FLO, la déviation par rapport à la valeur théorique -G0 nécessaire pour compenser parfaitement les pertes créées par le circuit résonnant décrit ci-dessus s'expliquant par les limitations de l'approximation au premier ordre évoquée plus haut. Cette déviation est toutefois minime et n'empêchera pas un oscillateur muni du circuit générateur de conductance négative conforme à l'invention de produire un signal ayant une pureté spectrale acceptable pour la plupart des applications envisageables dans l'état actuel de la technique.
A titre de comparaison, une courbe en pointillés NGC représente l'évolution de la valeur de la conductance négative générée à l'aide du montage connu, dans lequel les contre-réactions sont produites par des éléments capacitifs. On saisit bien les avantages de l'invention en comparant les variations de cette courbe NGC en fonction de la fréquence avec les très faibles variations de la valeur de la conductance négative NG obtenue grâce à l'invention.
En particulier, on observe que la valeur absolue de la conductance négative obtenue au moyen du montage connu augmente de manière significative avec la fréquence d'oscillation FLO. Cela conduit à une surcompensation des pertes dues à la conductance positive intrinsèque au circuit résonnant, surcompensation qui est génératrice de bruit et affecte la pureté spectrale du signal généré par l'oscillateur muni du montage connu.

La figure 6 illustre un mode de mise en oeuvre de l'invention. Cette figure représente schématiquement un appareil récepteur, par exemple un téléviseur, un magnétoscope, un boîtier-décodeur ou encore un radiotéléphone, incluant :
. un étage d'entrée, ici un système d'antenne AF, destiné à recevoir un signal radioélectrique et à le transformer en un signal électronique Vrf ayant une fréquence radio FR,
. un oscillateur OSC tel que décrit ci-dessus, destiné à produire un signal Vlo ayant une fréquence d'oscillation FLO, et
. un mélangeur MX.
Dans cet appareil, selon une technique bien connue de l'homme du métier, le mélangeur produit un signal de sortie Vfi ayant une fréquence intermédiaire IF de valeur fixe. De par la fonction même du mélangeur, la valeur de la fréquence intermédiaire IF est égale à la valeur absolue d'une différence entre les valeurs des fréquence radio FR et d'oscillation FLO, par exemple IF=FLO-FR si FLO>FR. Ainsi, la fréquence radio FR sélectionnée par réglage de la fréquence d'oscillation FLO sera égale à FLO-IF. Une bonne définition de la fréquence d'oscillation FLO, rendue possible sur l'ensemble de sa plage de variation grâce à l'invention, permettra donc une grande précision dans la sélection de la fréquence radio FR.

## Revendications

1. Oscillateur (OSC) comprenant :
- un premier transistor (T1) et un deuxième transistor (T2) connectés en paire différentielle et présentant des bornes de polarisation (A,B), des bornes de transfert reliées à une borne d'alimentation (VCC) via des résistances de charge (Rc), et des bornes de référence,
- un premier composant actif connecté entre la borne de polarisation du premier transistor (T1) et la borne de transfert du deuxième transistor (T2),
- un deuxième composant actif connecté entre la borne de polarisation du deuxième transistor (T2) et la borne de transfert du premier transistor (T1), **caractérisé en ce qu'**
- un circuit résonnant est connecté entre lesdites bornes de polarisation (A,B).

2. Oscillateur selon la revendication 1, dans lequel les premier et deuxième composants actifs sont constitués par des jonctions incluses dans des troisième et quatrième transistors (T3,T4).

3. Oscillateur selon la revendication 2, dans lequel les troisième et quatrième transistors (T3,T4) sont montés en diode.

4. Appareil récepteur de signaux radioélectriques comprenant :
- un étage d'entrée destiné à recevoir un signal ayant une fréquence radio,
- un oscillateur selon la revendication 1, 2, ou 3 destiné à produire un signal ayant une fréquence d'oscillation,
- un mélangeur destiné à produire un signal ayant une fréquence intermédiaire ayant une valeur égale à une différence entre les valeurs des fréquences radio et d'oscillation.

## Claims

1. An oscillator (OSC) comprising:
- a first transistor (T1) and a second transistor (T2) connected together as differential pair and provided with bias terminals (A,B), transfer terminals electrically connected to a supply terminal (VCC) via load resistors (Rc), and reference terminals,
- a first active component connected between the first transistor (T1) bias terminal and the second transistor (T2) transfer terminal,
- a second active component connected between the second transistor (T2) bias terminal and the first transistor (T1) transfer terminal,
**characterized in that**
- a resonant circuit is connected between the said bias terminals (A, B).

2. An oscillator as claimed in claim 1, wherein the first and second active components consist in junctions included in a third and a fourth transistors (T3, T4).

3. An oscillator as claimed in claim 2, wherein the third and fourth transistors (T3, T4) are mounted as diode transistors.

4. A radio signal receiving apparatus comprising:
- an input stage for receiving a signal with a radio frequency,
- an oscillator as claimed in claim 1, 2 or 3, for generating a signal with an oscillation frequency,
- a mixer for generating a signal with an intermediate frequency, which has a value made equal to a difference between the radiofrequency and oscillation frequency values.

## Patentansprüche

1. Schwingkreis (OSC), der folgendes umfasst:
- einen ersten Transistor (T1) und einen zweiten Transistor (T2), die als differentielles Paar miteinander verbunden sind und welche Polarisationsanschlüsse (A, B), über Lastwiderstände (Rc) mit einem Versorgungsanschluss (VCC) verbundene Durchgangsanschlüsse sowie Referenzanschlüsse aufweisen,
- eine erste aktive Komponente, die zwischen dem ersten Polarisationsanschluss des ersten Transistors (T1) und dem Durchgangsanschluss des zweiten Transistors (T2) angeschlossen ist,
- eine zweite aktive Komponente, die zwischen dem Polarisationsanschluss des zweiten Transistors (T2) und dem Durchgangsanschluss des ersten Transistors (T1) angeschlossen ist,
**dadurch gekennzeichnet, dass** ein Resonanzkreis zwischen den besagten Polarisationsanschlüssen (A, B) geschaltet ist.

2. Schwingkreis nach Anspruch 1, bei dem die erste und die zweite aktive Komponente aus in einem dritten und einem vierten Transistor (T3, T4) befindlichen Übergängen gebildet werden.

3. Schwingkreis nach Anspruch 2, wobei der dritte und der vierte Transistor (T3, T4) in Diodenform angebracht sind.

4. Empfangsgerät für radioelektrische Signale, welches folgendes umfasst:
- eine Eingangsstufe, die ein eine Funkfrequenz aufweisendes Signal empfangen soll;
- einen Schwingkreis nach einem der Ansprüche 1, 2 oder 3, der ausgebildet ist, ein eine Schwingfrequenz aufweisendes Signal zu erzeugen;
- einen Frequenzmischer, der ausgebildet ist, ein Signal zu erzeugen, welches eine Zwischenfrequenz aufweist, deren Wert der Differenz zwischen den Werten der Funk- und der Schwingfrequenz gleicht.
